(19) **Europäisches Patentamt / European Patent Office / Office européen des brevets**

(11) **EP 3 733 925 A1**

(12) **EUROPEAN PATENT APPLICATION**
published in accordance with Art. 153(4) EPC

(43) Date of publication:
**04.11.2020 Bulletin 2020/45**

(21) Application number: **18897331.7**

(22) Date of filing: **07.12.2018**

(51) Int Cl.:
*C23C 14/16* (2006.01)    *C23C 14/24* (2006.01)
*C22C 18/00* (2006.01)

(86) International application number:
**PCT/KR2018/015511**

(87) International publication number:
**WO 2019/132305 (04.07.2019 Gazette 2019/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.12.2017 KR 20170179506**

(71) Applicant: **POSCO**
**Gyeongsangbuk-do 37859 (KR)**

(72) Inventors:
• **KO, Kyoung-Pil**
 **Gwangyang-si, Jeollanam-do 57807 (KR)**
• **KIM, Tae-Yeob**
 **Gwangyang-si, Jeollanam-do 57807 (KR)**
• **NAM, Kyung-Hoon**
 **Gwangyang-si, Jeollanam-do 57807 (KR)**
• **JUNG, Yong-Hwa**
 **Gwangyang-si, Jeollanam-do 57807 (KR)**

(74) Representative: **Zech, Stefan Markus**
**Meissner Bolte Patentanwälte**
**Rechtsanwälte Partnerschaft mbB**
**Postfach 86 06 24**
**81633 München (DE)**

(54) **ZINC ALLOY PLATED STEEL SHEET HAVING EXCELLENT CORROSION RESISTANCE, WELDABILITY AND LUBRICITY, AND MANUFACTURING METHOD THEREFOR**

(57)    The present invention relates to a plated steel sheet used for vehicles, home appliances, steel materials for construction, and the like and, more specifically, to a zinc alloy plated steel sheet having excellent corrosion resistance, weldability and lubricity, and a method for manufacturing the same.

【Fig. 1】

(a)    (b)

(c)    (d)

EP 3 733 925 A1

**Description**

[Technical Field]

The present disclosure relates to a plated steel sheet used in automobiles, home appliances, steel materials for construction, and the like, and more specifically, to a zinc alloy plated steel sheet having excellent corrosion resistance, weldability and lubricity, and a method for manufacturing the same.

[Background Art]

A surface of steel sheet products used for automotive materials, home appliances, materials for construction, and the like, may be galvanized by electroplating or hot dip plating for the purpose of improving corrosion resistance and durability. Such a zinc-plated processed product has been applied to entire industries, because corrosion resistance is significantly improved by sacrificial corrosion resistance of zinc as compared to an unprocessed steel sheet product.

However, in recent years, in related industrial fields, as corrosion resistance is more excellent, and demand for lighter and more economical plated products is increasing, technology developments corresponding thereto have also been actively conducted. Further, since the price of zinc, a main raw material of the plated layer of the zinc plated steel sheet, is rapidly increasing, research to reduce a content of zinc to reduce a plating adhesion amount or replace zinc with other elements has been continued.

First, although a technique for reducing a plating adhesion amount of a plated steel sheet has been proposed, the plating adhesion amount is a factor that greatly affects corrosion prevention and long-term rust resistance of metals. As the plating adhesion amount increases, the time required for the occurrence of red rust increases, and corrosion resistance increases. Therefore, the plating adhesion amount cannot be reduced due to the problem of reducing corrosion resistance.

As another method, various studies on alloying combined with other materials using zinc have been conducted. Typically, as Zn-Mg alloy plating exhibits excellent corrosion resistance compared to zinc (Zn) plating, a variety of products have been developed including third elements such as alloys of Zn-Mg alloy or Zn-Mg-X (X=Al, Ni, Cr, Pb, Cu, or the like) alloy (Patent Document 1).

In the case of zinc-based plated steel sheets based on zinc, it is generally processed into parts by processing, or the like, and then welded by spot welding to be used as a product. However, in general, in the case of a zinc-based plated steel sheet made of high-strength steel as a base iron, a problem in which zinc is melted due to high heat generated during spot welding and diffuses along a grain boundary of the base iron to cause brittle cracks, that is a liquid metal embrittlement (LME) phenomenon occurs, is seriously has been arisen. As such, when LME cracks are generated in a welding portion, rigidity of the base iron is greatly reduced. Therefore, in the case of the zinc-based plated steel sheet made of high-strength steel as base iron, it is necessary to develop a technique for reducing the LME phenomenon generated in the welding portion.

On the other hand, as a factor to affect formability, such as press processing, or the like, to be used for existing automobile steel sheets, the lubricity of the surface of a plating material is considered important. Accordingly, in addition to high corrosion resistance, the lubricity of the plated steel sheet is also one of the items that must be secured in recent years, and at the same time, technology development is required.

(Patent Document 1) Japanese Patent Publication No. 2002-332555

[Disclosure]

[Technical Problem]

An aspect of the present disclosure relates to a zinc alloy plated steel sheet capable of minimizing crack generation during welding as well as having excellent corrosion resistance and lubrication properties of the plated layer, and a method manufacturing the same.

The problems to be solved by the present disclosure are not limited to the problems mentioned above, and other problems that are not mentioned will be clearly understood by those skilled in the art from the following description.

[Technical Solution]

An aspect of the present disclosure relates to a zinc alloy plated steel sheet having excellent corrosion resistance, weldability, and lubricity. According to an aspect of the present disclosure, the zinc alloy plated steel includes:

a base iron;

a Zn-Mg alloy layer formed on the base iron; and
a Zn layer formed on the Zn-Mg alloy layer,
wherein the Zn-Mg alloy layer has a region including a magnesium oxide in a lower portion thereof.

Another aspect of the present disclosure relates to a manufacturing method for a zinc alloy plated steel sheet having excellent corrosion resistance, weldability, and lubricity. According to another aspect of the present disclosure, the manufacturing method for the same, includes steps of:

preparing a base iron;
forming a Zn-Mg alloy layer on the base iron; and
forming a Zn layer on the Zn-Mg alloy layer,
wherein the Zn-Mg alloy layer and the Zn layer are formed by a vacuum deposition method, and when forming the Zn-Mg alloy layer, a degree of vacuum is $1 \times 10^{-4}$ to $1 \times 10^{-2}$ mbar.

[Advantageous Effects]

According to the present disclosure, it is possible to provide a zinc alloy plated steel sheet securing excellent corrosion resistance, having excellent lubrication properties of a plated layer, and having improved weldability by minimizing cracking during welding, and a method for manufacturing the same.

[Description of Drawings]

FIG. 1 shows an image (a) of a transmission electron microscope (TEM) observing a Zn-Mg alloy layer and mapping images (b,c,d) of each element of Zn, Mg, and O according to an embodiment of the present disclosure.
FIG. 2 is a graph showing a change in a friction coefficient according to an Mg content in the Zn-Mg alloy layer.
FIG. 3 shows (a) and (b) of corrosion resistance evaluation images of Comparative Example 6 and Inventive Example 5, respectively, of Examples of the present disclosure.

[Best Mode for Invention]

Hereinafter, the present disclosure will be described in detail. First, a zinc alloy plated steel sheet of the present disclosure will be described in detail.
A zinc alloy plated steel sheet according to an embodiment of the present disclosure includes a base iron and a Zn-Mg alloy layer formed on a surface of the base iron and a Zn layer formed on the Zn-Mg alloy layer. In addition, the Zn-Mg alloy layer includes a region including a magnesium oxide in a lower portion thereof.
On the other hand, the type of the base iron is not particularly limited, and any of hot-rolled steel sheets, cold-rolled steel sheets, wire rods, steel wires, or the like, may be used in the technical field to which the present disclosure pertains.
The region (hereinafter, the magnesium oxide region) including the magnesium oxide may exist in various forms, and as a preferred example, the magnesium oxide may exist in a particle form, and the magnesium oxide may have a layer form.
The magnesium oxide may act as a kind of diffusion barrier that prevents Zn or Mg from easily penetrating into the grain boundaries of the base iron during welding due to high thermal driving, and a role of preventing diffusion of the magnesium oxide, compared to Zn or Mg, may be further increased due to its high melting point.
Meanwhile, the magnesium oxide region may be included not only in the lower portion of the Zn-Mg alloy layer, but also included further in the upper portion thereof. The magnesium oxide region existing in the upper portion may serve as an additional diffusion preventing layer to prevent thermal diffusion of the Zn layer existing above the Zn-Mg alloy layer during welding.

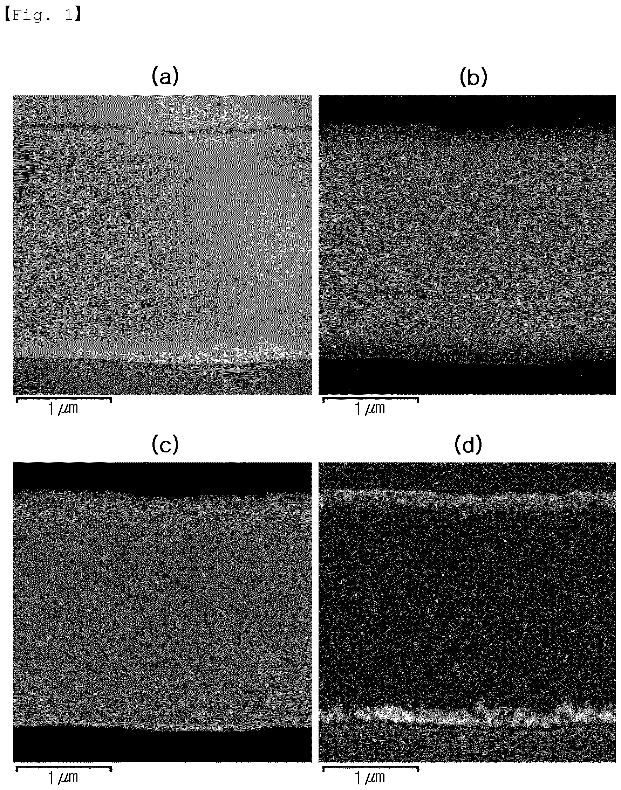

FIG. 1 shows an image (a) of a transmission electron microscope observing a Zn-Mg alloy layer and mapping images (b,c,d) of each element of Zn, Mg, and O according to an embodiment of the present disclosure. It can be seen that in the Zn-Mg alloy layer of the zinc alloy plated steel sheet shown in FIG. 1, a magnesium oxide is distributed on upper and lower portions. Specifically, in FIG. 1(d), a bright region means that O is distributed, and it can be seen that it is mainly distributed in an upper portion or a lower portion of the Zn-Mg plating layer . Compared thereto, in (b) and (c) of FIG. 1, it can be seen that Zn and Mg are distributed throughout the entire plating layer. It can be seen that a region overlapping with a bright region shown in (d) of FIG. 1 is Mg in (c), and an oxide layer existing in the upper and lower portions in (d) is a magnesium oxide.

The thickness of the magnesium oxide region formed on the lower portion or the upper and lower portions of the Zn-Mg alloy layer is preferably 12 to 35% of the total thickness of the Zn-Mg alloy layer. If the thickness of the magnesium oxide region is too small, it is difficult to expect an effect due to the presence of the magnesium oxide region, and if the thickness of the magnesium oxide region is too wide, the corrosion resistance and lubricity of the Zn-Mg alloy layer may be deteriorated.

Meanwhile, the thickness of the Zn-Mg alloy layer is preferably 0.5 to 2 $\mu$m. When the thickness of the Zn-Mg alloy layer is less than 0.5 $\mu$m, it is difficult to secure an effect of increasing sufficient corrosion resistance exerted in the Zn-Mg alloy layer. On the other hand, when the thickness thereof exceeds 2 $\mu$m, as the thickness of the plating layer becomes too thick, a degree of cracking may become severe during welding.

The Mg content included in the Zn-Mg alloy layer is preferably 20% by weight or more and less than 39% by weight. When the Mg weight is deposited to less than 20% by weight, as the magnesium oxide formed on the lower portion or the upper and lower portions of the Zn-Mg alloy layer is not sufficiently formed or grown, an amount of the magnesium oxide that serves to prevent cracking during welding is insufficient, so it is difficult to suppress crack generation. On the other hand, in the case of more than 39% by weight, the amount of magnesium oxide formed on the lower portion or the upper and lower portions of the Zn-Mg alloy layer is sufficient, but separately thereto, as pure Mg particles are also formed inside the Zn-Mg alloy layer, uniformity of the Zn-Mg alloy layer is deteriorated, and as a result, the corrosion resistance may be lowered, and the lubricity of the plated layer can be equally inferior.

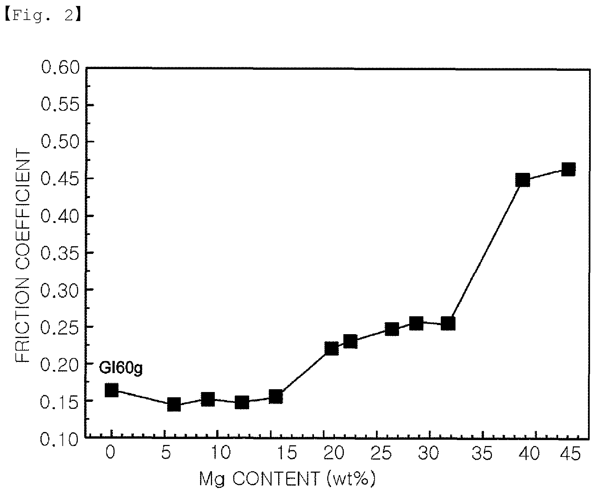

The Zn layer formed on the Zn-Mg alloy layer serves to supplement the lubrication properties of the Zn-Mg alloy layer. FIG. 2 is a graph showing a change in a friction coefficient according to Mg content in a Zn-Mn alloy layer. As shown in FIG. 2, when the Mg content in the Zn-Mg alloy layer exceeds 20% by weight, the friction coefficient increases to 0.2 or more, resulting in poor lubricity. To supplement this, a Zn layer is formed on the Zn-Mg alloy layer. In addition, when the Zn-Mg alloy layer is directly exposed to the surface, a blackening phenomenon due to the Mg component may occur, so it can also serve as a kind of protective film to prevent this.

The thickness of the Zn layer is preferably 0.5 to 2 $\mu$m. When the thickness is less than 0.5 $\mu$m, the thickness of the Zn-Mg alloy layer is insufficient to supplement the thermal frictional properties, so it is difficult to expect a sufficient lubricity supplementary effect. When the thickness exceeds 2 $\mu$m, not only is it difficult to expect a lubricity improvement effect, but also is it undesirable because it is inefficient because it forms an unnecessary coating layer.

Hereinafter, an embodiment of the method for manufacturing the zinc alloy plated steel sheet of the present disclosure will be described in detail.

The zinc alloy plated steel sheet of the present disclosure steps of: preparing a base iron; forming a Zn-Mg alloy layer on the prepared base iron; and forming a Zn layer on the Zn-Mg alloy layer.

In a process of preparing the base iron, it may include a process of removing a surface foreign matter or an oxide film (scale) attached to the surface of the base iron. The method for removing the foreign matter or the oxide film is not particularly limited, and may be removed, for example, by plasma etching using an ion beam. As described above, a plating layer is formed on a surface of a base steel sheet from which the foreign matter and the oxide film have been removed.

The process of forming the Zn-Mg alloy layer may be preferably formed by using a Zn and Mg source individually or using a vacuum deposition method using a Zn-Mg alloy source. The Zn-Mg alloy layer is preferably formed so that the Mg content is 20% by weight or more and less than 39% by weight.

The vacuum deposition method may be applied by an electron beam method, sputtering method, a thermal evaporation method, an induction heating evaporation method, an ion plating method, or the like, preferably, high-speed deposition is possible to improve a production speed, and it is preferable to be formed by an electromagnetic flotation induction heating method having an electromagnetic stirring effect.

During the deposition of the Zn-Mg alloy layer (for example, deposition by an electromagnetic floating induction heating deposition method), the vaporized Zn-Mg vapor passes through a spray nozzle that is drilled in a circular shape before being deposited on the base iron. The plurality of nozzles may be formed in a circular form, and may be formed at uniform sizes and intervals over an entire width of the base iron so that uniform spraying may be performed. In this case, the sprayed Zn-Mg vapor is sprayed in a fan-shaped shape based on a side observation while passing through the nozzle, and the density of the sprayed vapor has the highest middle region among the upper and lower regions, and the upper and lower regions have a lower density distribution than the middle region. This vapor distribution reacts with oxygen remaining in the chamber, and the Zn-Mg vapor having a low density in the upper and lower regions is more likely to react with the residual oxygen, thereby increasing the possibility of forming a magnesium oxide . During this deposition, the magnesium oxide may be deposited before and after the growth of the Zn-Mg alloy layer due to the structure according to the movement of the nozzle and the substrate.

When the Zn-Mg alloy layer is vacuum deposited, it is preferable to use a nozzle plate including a plurality of nozzles in a horizontal direction with respect to a moving base iron (strip). The nozzles formed on the nozzle plate are preferably formed in three or more rows, and more preferably 3 to 7 rows, with respect to a moving direction of the base iron. Depending on the number of nozzles, a difference in density occurs depending on the angle of the vapor to be sprayed, so that an appropriate magnesium oxide region can be formed at the beginning of and the end of deposition in the moving base iron.

When formed by depositing the Zn-Mg alloy layer, a degree of vacuum in the chamber is preferably $1\times10^{-4}$ to $1\times10^{-2}$ mbar. As described above, due to residual oxygen in the chamber, an Mg component inside the Zn-Mg vapor is partially oxidized to form a magnesium oxide, and the magnesium oxide may be formed in a particle form or a layer form at a predetermined thickness or more in the lower portion or upper and lower portions of the Zn-Mg alloy layer to minimize diffusion of Zn and Mg during welding. The degree of vacuum is more preferably $5\times10^{-4}$ to $5\times10^{-3}$ mbar.

After depositing the Zn-Mg alloy layer, a Zn layer is formed. The method for forming the Zn layer is not particularly limited, but may be formed by, for example, using a method of vacuum deposition using a Zn source.

[Mode for Invention]

Hereinafter, embodiments of the present disclosure will be described in detail. The following Examples are only for understanding the present disclosure and are not intended to limit the present disclosure.

(Example)

After loading a cold-rolled steel sheet into a vacuum chamber with a base iron substrate for coating and removing foreign matters and natural oxide films on the surface through plasma pretreatment, a Zn-Mg alloy layer and a Zn layer were coated using an electromagnetic floating induction heating deposition method, a kind of a vacuum deposition method. A zinc alloy plated steel sheet was manufactured by varying an Mg content of the Zn-Mg alloy layer to 6 to 43% by weight.

The vacuum deposition forming the Zn-Mg alloy layer and the Zn layer was undertaken coating by spraying Zn-Mg and Zn materials in a vertical direction to the cold-rolled steel sheet moving in a horizontal direction with a nozzle using a nozzle plate having 5 rows of 3 mm diameter nozzles. In this case, the degree of vacuum of the chamber was adjusted to maintain 5 to $8\times10^{-4}$, and the total number of coating chambers used was two, in a primary coating chamber, a Zn-Mg alloy layer was formed, and in a secondary chamber, a Zn layer was coated. The thickness of each coating layer was prepared as shown in Table 1 below.

With respect to the prepared plated steel sheet, the thicknesses of the magnesium oxide regions formed on upper and lower portions of the Zn-Mg alloy layer were respectively observed, and were shown in Table 1 below as a ratio to the total thickness of the Zn-Mg alloy layer.

In an evaluation of corrosion resistance, a coating sample was subjected to a salt spray test under conditions of a salt concentration of 5%, a temperature of 35°C, and a spraying pressure of 1 kg/cm$^2$, and the time at which red rust was generated at 5% was measured. As an evaluation criterion of the result of the evaluation of corrosion resistance, it was evaluated as OK for 120 hours or more and as NG for less than 120 hours.

Weldability was measured by cutting 40 mm*120 mm specimens according to SEP 1220-2 standards, and then spot welding was performed on each specimen to observe the cracks (so-called Type B) of the welding portion to measure the maximum crack depth. As a result of the evaluation, it was evaluated as OK when the maximum crack depth was less than 100 $\mu$m and as NG when it exceeded 100 $\mu$m.

Evaluation of the lubricity is 50 (W) * 200 (L) mm cut to the coated steel sheet produced above, and then moves a friction tip (size: 35* 45mm) under the condition of load (N) 600 kg, speed 1000 mm/min, and moving distance 200 mm, to calculate the lubricity of the surface as the friction coefficient ($\mu$) value. A formula for calculating the friction coefficient is as follows.

$$\text{Friction coefficient } (\mu) = \text{Friction force of specimen (f)} / \text{Load of friction tip (N)}$$

If a friction coefficient value obtained by the above formula was 0.2 or less, it was evaluated as good (O), and if it exceeded 0.2, it was evaluated as bad (X).

[Table 1]

| | | Zn-Mg alloy layer | | | | Thickness of Zn layer ($\mu$m) | Corrosion resistance | Spot weldability | Lubricity |
|---|---|---|---|---|---|---|---|---|---|
| | | Lower magnesium oxide region (%) | Upper magnesium oxide region (%) | Thickness ($\mu$m) | Mg content (by weight %) | | | | |
| CE 1 | | 1 | 2 | 2 | 6 | 1 | OK | NG | ○ |
| CE 2 | | 2.8 | 3.2 | 2 | 9 | 1 | OK | NG | ○ |
| CE 3 | | 4.1 | 4.1 | 2 | 12 | 1 | OK | NG | ○ |
| CE 4 | | 5 | 5.2 | 2 | 15 | 1 | OK | NG | ○ |
| IE 1 | | 6 | 7 | 2 | 21 | 1 | OK | OK | ○ |
| IE 2 | | 9.5 | 10.1 | 2 | 23 | 1 | OK | OK | ○ |
| IE 3 | | 11.5 | 12. | 2 | 26 | 1 | OK | OK | ○ |
| IE 4 | | 13 | 14 | 2 | 29 | 1 | OK | OK | ○ |
| IE 5 | | 15 | 16 | 2 | 32 | 1 | OK | OK | ○ |
| CE 5 | | 19 | 21 | 2 | 39 | 1 | NG | OK | × |
| CE 6 | | 23 | 25 | 2 | 43 | 1 | NG | OK | × |
| CE 7 | | 15 | 6.5 | 0.3 | 32 | 1 | NG | OK | ○ |
| IE 6 | | 4.5 | 15 | 1 | 32 | 1 | OK | OK | ○ |
| CE 8 | | 17 | 19 | 3 | 32 | 1 | OK | NG | ○ |
| CE 9 | | 15 | 16 | 2 | 32 | 0.3 | OK | OK | × |
| IE 7 | | 15 | 16 | 2 | 32 | 1.5 | OK | OK | ○ |
| CE 10 | | 15 | 16 | 2 | 32 | 3 | OK | NG | ○ |
| CE: Comparative Example IE: Invention Example | | | | | | | | | |

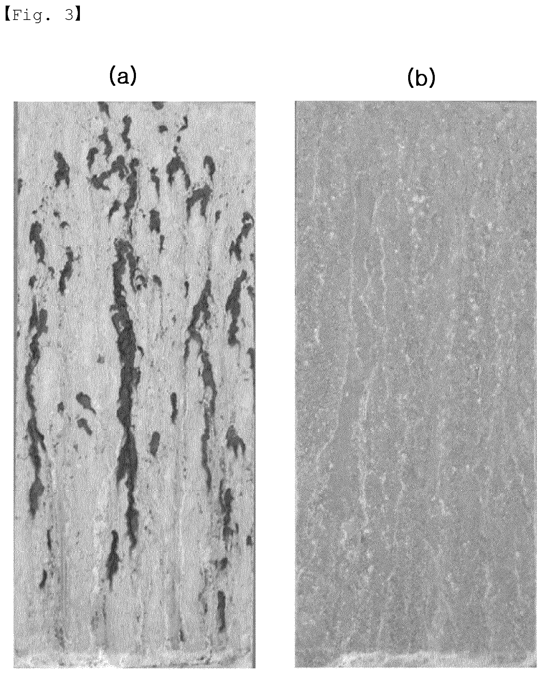

Meanwhile, (a) and (b) of FIG. 3 are corrosion resistance evaluation images of Comparative Example 6 and Inventive Example 5, respectively. As can be seen from the results of Table 1 and FIG. 3, in the case of the Invention Examples satisfying the conditions of the present disclosure, excellent corrosion resistance, weldability and lubricity can be secured.

On the other hand, in Comparative Examples 1 to 4, which do not have the magnesium oxide region defined in the present disclosure, corrosion resistance and lubricity was excellent, but cracks occurred during spot welding. On the other hand, in the case of Comparative Examples 5 and 6 having an excessive magnesium oxide region, it can be seen that the specific gravity of the alloy phase decreases as the magnesium oxide present in the plating layer increases, resulting in a decrease in corrosion resistance and lubricity.

Meanwhile, in Comparative Example 7 in which the Zn-Mg alloy layer was too thin, it could be confirmed that it was difficult to secure sufficient corrosion resistance, and in Comparative Example 8 in which the thickness of the magnesium oxide region was excessive and the Zn-Mg alloy layer was thick, it was confirmed that the weldability was deteriorated. In Comparative Examples 9 and 10 in which the Zn layer was too thin or thick, it can be confirmed that the lubricity was poor or the weldability was poor, respectively.

While exemplary embodiments have been shown and described above, it will be apparent to those skilled in the art that modifications and variations could be made without departing from the scope of the present invention as defined by the appended claims.

**Claims**

1. A zinc alloy plated steel sheet having excellent corrosion resistance, weldability, and lubricity, comprising:

   a base iron;
   a Zn-Mg alloy layer formed on the base iron; and
   a Zn layer formed on the Zn-Mg alloy layer,
   wherein the Zn-Mg alloy layer has a region comprising a magnesium oxide in a lower portion thereof.

2. The zinc alloy plated steel sheet having excellent corrosion resistance, weldability and lubricity of claim 1, wherein the region comprising the magnesium oxide is further comprised in an upper portion of the Zn-Mg alloy layer.

3. The zinc alloy plated steel sheet having excellent corrosion resistance, weldability and lubricity of claim 1, wherein the region comprising the magnesium oxide is formed in a particle form, a layer form, or a composite form thereof.

4. The zinc alloy plated steel sheet having excellent corrosion resistance, weldability and lubricity of claim 1 or 2, wherein a thickness of the region comprising the magnesium oxide is 12 to 35% of the total thickness of the Zn-Mg alloy layer.

5. The zinc alloy plated steel sheet having excellent corrosion resistance, weldability and lubricity of claim 1, wherein the Zn-Mg alloy layer has an Mg content of 20 wt% or more and less than 39 wt%.

6. The zinc alloy plated steel sheet having excellent corrosion resistance, weldability and lubricity of claim 1, wherein the Zn-Mg alloy layer has a thickness of 0.5 to 2 $\mu$m.

7. The zinc alloy plated steel sheet having excellent corrosion resistance, weldability and lubricity of claim 1, wherein the Zn layer has a thickness of 0.5 to 2 $\mu$m.

8. A manufacturing method for a zinc alloy plated steel sheet having excellent corrosion resistance, weldability, and lubricity, comprising steps of:

   preparing a base iron;
   forming a Zn-Mg alloy layer on the base iron; and
   forming a Zn layer on the Zn-Mg alloy layer,
   wherein the Zn-Mg alloy layer and the Zn layer are formed by a vacuum deposition method, and when forming the Zn-Mg alloy layer, a degree of vacuum is $1 \times 10^{-4}$ to $1 \times 10^{-2}$ mbar.

9. The manufacturing method for the zinc alloy plated steel sheet having excellent corrosion resistance, weldability, and lubricity of claim 8, wherein nozzles formed in three or more rows formed on a nozzle plate are used during vacuum deposition for forming the Zn-Mg alloy layer.

10. The manufacturing method for the zinc alloy plated steel sheet having excellent corrosion resistance, weldability, and lubricity of claim 8, wherein the Zn-Mg alloy layer is formed such that an Mg content is 20 wt% or more and less than 39 wt%.

【Fig. 1】

(a)

(b)

(c)

(d)

【Fig. 2】

【Fig. 3】

(a)                                        (b)

## INTERNATIONAL SEARCH REPORT

| | International application No. |
|---|---|
| | **PCT/KR2018/015511** |

**A. CLASSIFICATION OF SUBJECT MATTER**

*C23C 14/16(2006.01)i, C23C 14/24(2006.01)i, C22C 18/00(2006.01)i*

According to International Patent Classification (IPC) or to both national classification and IPC

**B. FIELDS SEARCHED**

Minimum documentation searched (classification system followed by classification symbols)

C23C 14/16; B32B 15/04; C23C 14/06; C23C 14/58; C23C 2/04; C23C 2/26; C23C 30/00; C23C 8/12; C25D 3/66; C25D 5/16; C23C 14/24; C22C 18/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: base steel, Zn-Mg alloy layer, Zn layer, magnesium oxide, corrosion resistance, lubricating, Zn alloy plating steel sheet

**C. DOCUMENTS CONSIDERED TO BE RELEVANT**

| Category* | Citation of document, with indication, where appropriate, of the relevant passages | Relevant to claim No. |
|---|---|---|
| Y | JP 09-137267 A (NISSHIN STEEL CO., LTD.) 27 May 1997<br>See paragraphs [0001]-[0013]; claims 1-2; and figure 1. | 1-10 |
| Y | KR 10-2014-0083836 A (POSCO) 04 July 2014<br>See paragraphs [0015]-[0036]; and claims 1-10. | 1-10 |
| A | JP 08-003728 A (NISSHIN STEEL CO., LTD.) 09 January 1996<br>See paragraphs [0005]-[0014]; and claims 1-3. | 1-10 |
| A | KR 10-2016-0027319 A (POSCO) 10 March 2016<br>See paragraphs [0014]-[0042]; and claims 1-7. | 1-10 |
| A | KR 10-1991-0008175 A (KAWASAKI STEEL CO.) 30 May 1991<br>See claims 1-7. | 1-10 |

☐ Further documents are listed in the continuation of Box C.　　☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 MARCH 2019 (13.03.2019) | **13 MARCH 2019 (13.03.2019)** |

| Name and mailing address of the ISA/KR | Authorized officer |
|---|---|
| Korean Intellectual Property Office<br>Government Complex Daejeon Building 4, 189, Cheongsa-ro, Seo-gu, Daejeon, 35208, Republic of Korea<br>Facsimile No. +82-42-481-8578 | Telephone No. |

Form PCT/ISA/210 (second sheet) (January 2015)

**INTERNATIONAL SEARCH REPORT**
Information on patent family members

International application No.

**PCT/KR2018/015511**

| Patent document cited in search report | Publication date | Patent family member | Publication date |
|---|---|---|---|
| JP 09-137267 A | 27/05/1997 | NONE | |
| KR 10-2014-0083836 A | 04/07/2014 | CN 104903493 A | 09/09/2015 |
| | | CN 104903493 B | 24/04/2018 |
| | | EP 2940191 A1 | 04/11/2015 |
| | | EP 2940191 A4 | 04/11/2015 |
| | | EP 2940191 B1 | 16/05/2018 |
| | | JP 2016-503837 A | 08/02/2016 |
| | | JP 2017-145508 A | 24/08/2017 |
| | | JP 6346972 B2 | 20/06/2018 |
| | | JP 6346972 B6 | 18/07/2018 |
| | | KR 10-1439694 B1 | 12/09/2014 |
| | | US 2015-0352812 A1 | 10/12/2015 |
| | | US 9744743 B2 | 29/08/2017 |
| | | WO 2014-104445 A1 | 03/07/2014 |
| JP 08-003728 A | 09/01/1996 | JP 3545051 B2 | 21/07/2004 |
| KR 10-2016-0027319 A | 10/03/2016 | KR 10-1639877 B1 | 15/07/2016 |
| KR 10-1991-0008175 A | 30/05/1991 | EP 0424856 A1 | 02/05/1991 |
| | | EP 0424856 B1 | 10/08/1994 |
| | | JP 03-138389 A | 12/06/1991 |
| | | KR 10-1993-0000469 B1 | 21/01/1993 |
| | | US 5021301 A | 04/06/1991 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2002332555 A